# EUROPÄISCHE PATENTANMELDUNG

(11) **EP 0 732 420 A2**
(43) Veröffentlichungstag der Anmeldung: **18.09.1996**
(21) Anmeldenummer: 96103851.0
(22) Anmeldetag: 12.03.1996
(51) Int. Cl.: C23C 14/04, C23C 16/04, C23C 14/34, C23C 16/50

(54) **Verfahren zum Versehen einer transparenten Trägerplatte mit einer gleichmässig dünnen Metallschicht**

(30) Priorität: 15.03.1995 DE 19509286; 08.09.1995 DE 19533862
(71) Anmelder: FRITZ BORSI KG, D-77746 Schutterwald (DE)
(72) Erfinder: Fritsch, Günther, 77743 Neuried (DE)
(74) Vertreter: Goddar, Heinz J., Dr.

(57) **Zusammenfassung**

Verfahren zum Versehen einer transparenten Trägerplatte mit einer gleichmäßig dünnen Metallschicht, bei dem auf mindestens eine Seite der Trägerplatte zunächst, vorzugsweise im Siebdruckverfahren, eine Abdeckfolie aufgebracht wird, welche lediglich die nicht zu beschichtenden Bereiche der Trägerplatte abdeckt, anschließend eine Metallschicht mittels eines Plasmabedampfungsverfahrens auf die gesamte, die Abdeckfolie tragende Fläche der Trägerplatte aufgebracht wird, wobei zur Durchführung des Plasmabedampfungsverfahrens mindestens eine eine Kathode und Anode mit einem Tiegel umfassende Verdampfer-Einheit eingesetzt wird, und schließlich die Abdeckfolie von der Trägerplatte entfernt wird, wodurch die Metallschicht lediglich in den zu beschichtenden Bereichen der Trägerplatte auf dieser verbleibt, dadurch gekennzeichnet, daß zur Herstellung der Metallschicht bei jeder Verdampfer-Einheit ein Draht aus einem mindestens ein Metall umfassenden Verdampfungsmaterial von oben und oberhalb des Tiegels in einen zwischen der jeweiligen Anode und dazu im wesentlichen horizontal versetzt angeordneten jeweiligen Kathode bestehenden Plasma-Vakuumlichtbogen derart eingeführt wird, daß sich einzelne Tröpfchen von dem Draht lösen und momentan im wesentlichen vollständig verdampfen, die Schichtdicke in dem der jeweiligen Verdampfer-Einheit zugeordneten Bereich der zu beschichtenden Trägerplatte gemessen wird und die Vorschubgeschwindigkeit des Drahtes sowie die Heizleistung jeder Verdampfer-Einheit zum Erzielen einer vorab festgelegten gleichmäßigen Schichtdicke in Abhängigkeit von dem/den gemessenen Schichtdickenwert(en) individuell geregelt werden.

## Beschreibung

Die vorliegende Erfindung betrifft ein Verfahren zum Versehen einer transparenten Trägerplatte mit einer gleichmäßig dünnen Metallschicht, bei dem auf mindestens eine Seite der Trägerplatte zunächst, vorzugsweise im Siebdruckverfahren, eine Abdeckfolie aufgebracht wird, welche lediglich die nicht zu beschichtenden Bereiche der Trägerplatte abdeckt, anschließend eine Metallschicht mittels eines Plasmabedampfungsverfahrens auf die gesamte, die Abdeckfolie tragende Fläche der Trägerplatte aufgebracht wird, wobei zur Durchführung des Plasmabedampfungsverfahrens mindestens eine eine Kathode und Anode mit einem Tiegel umfassende Verdampfer-Einheit eingesetzt wird, und schließlich die Abdeckfolie von der Trägerplatte entfernt wird, wodurch die Metallschicht lediglich in den zu beschichtenden Bereichen der Trägerplatte auf dieser verbleibt.

Aus z.B. der DE-PS 3 808 689 und DE-PS 4 224 463 sind Verfahren bekannt, bei denen zum selektiven, bereichsweisen Beschichten einer transparenten, gegebenenfalls aus klarem Acrylglas bestehenden Trägerplatte mit einem metallischen Material in Form einer metallischen Prägefolienbeschichtung auf die Trägerplatte zunächst im Siebdruckverfahren eine Abdeckfolie aufgebracht wird, welche lediglich die nicht zu beschichtenden Bereiche der Trägerplatte abdeckt, woraufhin im Rollenprägeverfahren die Prägefolie auf die gesamte die Abdeckfolie tragende Fläche der Trägerplatte aufgebracht, anschließend die Abdeckfolie von der Trägerplatte abgezogen und vorzugsweise im Siebdruckverfahren auf die Trägerplatte eine die mittels der Prägefolienbeschichtung bewirkte Farbgebung unterstützende Farbschicht aufgebracht wird. Diese Verfahren weisen jedoch den Nachteil auf, daß die Prägefolienbeschichtung nicht ausreichend fest an der Trägerplatte haftet und somit das spätere Abziehen der Abdeckfolie erschwert wird. Außerdem wird das Abziehen der Abdeckfolie ("Schablone"), wenn diese im Siebdruckverfahren auf die Trägerplatte aufgedruckt worden ist, schwierig, wenn die metallische Wirkschicht im Rollenprägeverfahren aufgebracht worden ist.

In der DE-PS 3 601 040 wird ein Verfahren zur Herstellung von Mustern auf (transparenten) Substraten aus z.B. Epoxidharz mit Glasfaserverstärkung durch Maskierung mittels Aufbringen von ca. 30 µm eines Lackes, Schneiden von Mustern in den Lackfilm mittels z.B. einer CNC-Werkzeugmaschine, Bedampfen mit Metall und Abziehen der die Maske bildenden Teile der Lackfolie beschrieben, so daß ein Abriß der Aufdampfschicht an den Schnittkanten erfolgt, ohne daß das Metallmuster beschädigt wird.

Weiterhin wird in der JP-62-188779 A die Musterung eines Substrates beschrieben, wobei eine Abdeckfolie durch z.B. Siebdruck auf das Substrat aufgebracht, eine Metallschicht mittels Plasma-CVD abgeschieden und die Maskierungsfolie schließlich abgezogen wird, so daß auf dem Substrat ein Metallmuster hinterbleibt.

Darüber hinaus wird in der DE-OS 3 924 716 die Herstellung von Leiterbahnmustern auf Substraten aus Kunststoff, (transparentem) Glas oder Keramik, die mit einem photolithographischen Lackmuster versehen sind, mittels Lichtbogenplasma-Aufdampfen von Kupfer und/oder Nickel sowie ein Abziehen des (Negativ-)Musters mit einer Haftklebefolie beschrieben.

Die drei letztgenannten Verfahren weisen die Nachteile auf, daß durch ein (Plasma-)Bedampfen nur große Schichtdicken (> 100 nm) mit einer über größere Flächen (> 1 m²) großen Ungleichmäßigkeit erzielt werden können, womit ein schlechter optischer Gesamteindruck verbunden ist.

Der Erfindung liegt somit die Aufgabe zugrunde, ein Verfahren zur Verfügung zu stellen, mit dem eine bessere Haftung einer darüber hinaus dünneren und gleichmäßigeren Metallschicht auf einer Trägerplatte erzielt wird.

Erfindungsgemäß wird diese Aufgabe dadurch gelöst, daß zur Herstellung der Metallschicht bei jeder Verdampfer-Einheit ein Draht aus einem mindestens ein Metall umfassenden Verdampfungsmaterial von oben und oberhalb des Tiegels in einen zwischen der jeweiligen Anode und dazu im wesentlichen horizontal versetzt angeordneten jeweiligen Kathode bestehenden Plasma-Vakuumlichtbogen derart eingeführt wird, daß sich einzelne Tröpfchen von dem Draht lösen und momentan im wesentlichen vollständig verdampfen, die Schichtdicke in dem der jeweiligen Verdampfer-Einheit zugeordneten Bereich der zu beschichtenden Trägerplatte gemessen wird und die Vorschubgeschwindigkeit des Drahtes sowie die Heizleistung jeder Verdampfer-Einheit zum Erzielen einer vorab festgelegten gleichmäßigen Schichtdicke in Abhängigkeit von dem/den gemessenen Schichtdickenwert(en) individuell geregelt werden.

Dabei kann vorgesehen sein, daß der Aufbau jeder Schicht in dem der jeweiligen Verdampfer-Einzeit zugeordneten Bereich der zu beschichtenden Trägerplatte in Abhängigkeit von dem/den gemessenen Schichtdickenwert(en) mittels jeweils mindestens einer gesteuert zu öffnenden bzw. zu schließenden Blende zusätzlich geregelt wird.

Weiterhin kann vorgesehen sein, daß die Blende(n) durch Schwenken geöffnet bzw. geschlossen wird/werden.

Ferner kann vorgesehen sein, daß die Trägerplatte im wesentlichen quer zur Bewegungsrichtung des erzeugten Material-Dampfes bewegt wird.

Die Erfindung schlägt weiterhin vor, daß die Metallschicht vor einer Verformung der Trägerplatte aufgebracht wird.

Die Erfindung schlägt vor, daß die Metallschicht nach einer Verformung der Trägerplatte aufgebracht wird.

Die Erfindung schlägt weiterhin vor, daß die Abdeckfolie durch Abziehen entfernt wird.

Weiterhin schlägt die Erfindung vor, daß die Abdeckfolie durch Laserbestrahlung entfernt wird.

Die Erfindung schlägt vor, daß die Abdeckfolie durch Auswaschen entfernt wird.

Die Erfindung schlägt weiterhin vor, daß die Abdeckfolie durch chemisches Ablösen entfernt wird.

Andererseits kann auch vorgesehen sein, daß die Abdeckfolie mittels eines Plottern-Verfahrens entfernt wird.

Weiterhin schlägt die Erfindung vor, daß auf mindestens eine Seite der Trägerplatte mindestens eine Farbschicht aufgebracht wird.

Die Erfindung schlägt weiterhin vor, daß mindestens eine Farbschicht unmittelbar auf die Trägerplatte aufgebracht wird.

Die Erfindung schlägt vor, daß mindestens eine Farbschicht nach dem Aufbringen der Metallschicht auf diese aufgebracht wird.

Weiterhin schlägt die Erfindung vor, daß mindestens eine Farbschicht nach dem Aufbringen der Abdeckfolie auf die diese tragende Trägerplatte aufgebracht wird.

Die Erfindung schlägt weiterhin vor, daß mindestens eine Farbschicht vor dem Abziehen der Abdeckfolie auf die Metallschicht aufgebracht wird.

Die Erfindung schlägt vor, daß mindestens eine Farbschicht nach dem Abziehen der Abdeckfolie aufgebracht wird.

Weiterhin schlägt die Erfindung vor, daß mindestens eine Farbschicht selektiv in den mit die Metallschicht versehenen oder zu versehenden Bereichen aufgebracht wird.

Die Erfindung schlägt vor, daß mindestens eine Farbschicht im Siebdruckverfahren aufgebracht wird.

Die Erfindung schlägt weiterhin vor, daß für die Farbschicht eine Farbfolie, vorzugsweise aus Kunststoff bestehend, verwendet wird.

Weiterhin schlägt die Erfindung vor, daß die gesamte Beschichtung auf die Vorderseite der Trägerplatte aufgebracht wird.

Die Erfindung schlägt vor, daß die gesamte Beschichtung auf die Rückseite der Trägerplatte aufgebracht wird.

Die Erfindung schlägt weiterhin vor, daß als Metallschicht eine Silberlegierung und für mindestens eine Farbschicht mindestens bereichsweise den an sich durch die Silberlegierung bewirkten Silberton der Beschichtung in einen Goldton umwandelnde gelbe Farbe verwendet werden.

Weiterhin schlägt die Erfindung vor, daß als Metallschicht eine Goldlegierung verwendet wird.

Alternativ kann vorgesehen sein, daß als Metallschicht eine Messinglegierung verwendet wird.

Die Erfindung schlägt vor, daß auf mindestens eine Seite der Trägerplatte eine Schutzschicht aufgebracht wird.

Die Erfindung schlägt weiterhin vor, daß die Schutzschicht zuäußerst angeordnet wird.

Die Erfindung schlägt vor, daß die Schutzschicht transparent ist.

Weiterhin schlägt die Erfindung vor, daß die Trägerplatte aus Glas besteht.

Die Erfindung schlägt weiterhin vor, daß die Trägerplatte aus Kunststoff besteht.

Weiterhin schlägt die Erfindung vor, daß der Kunststoff Acrylglas umfaßt.

Darüber hinaus kann vorgesehen sein, daß beide Seiten der Trägerplatte glatt sind.

Alternativ dazu kann vorgesehen sein, daß mindestens eine der Seiten der Trägerplatte eine Oberflächenstrukturierung aufweist.

Dabei kann vorgesehen sein, daß sich die Oberflächenstrukturierung durch Ätzen ergibt.

Ferner kann vorgesehen sein, daß sich die Oberflächenstrukturierung durch Schleifen ergibt.

Schließlich kann vorgesehen sein, daß in einer bevorzugten Ausführungsform die Metallegierung auf eine Seite mit der Oberflächenstrukturierung aufgebracht wird.

Eine Oberflächenstrukturierung führt zu einer Streuung des Lichts und liefert einen besonderen optischen Eindruck insbesondere in Kombination mit einer auf derselben Seite angeordneten Metallschicht.

Der Erfindung liegt die überraschende Erkenntnis zugrunde, daß durch die erfindungsgemäße Verwendung eines Drahtes aus einem mindestens ein Metall umfassenden Verdampfungsmaterial, der in einen Plasma-Vakuumlichtbogen gemäß dem erfindungsgemäßen Verfahren eingeführt wird, mittels Plasmabedampfung eine besonders dünne Metallschicht mit einer auch über größere Flächen hohen Gleichmäßigkeit erzielt wird. Darüber hinaus gelingt mit dem erfindungsgemäßen Verfahren sogar eine Bedampfung mit Metallegierungen. Dies ist unter dem Aspekt zu sehen, daß ein gleichmäßiges Verdampfen derartiger Metallegierungen aus der Anode zugeordneten Tiegeln herkömmlicher Verdampfer-Einheiten sehr schwierig ist, weil die einzelnen Bestandteile der Legierung unterschiedliche Verdampfungstemperaturen aufweisen. Mit dem vorliegenden Verfahren gelingt es jedoch, einen Metalldampf zu erhalten, der tatsächlich sämtliche Legierungsanteile in der für den Legierungsdraht vorgesehenen Zusammensetzung enthält.

Das erfindungsgemäße Verfahren eignet sich wegen der hohen Energie der für die Beschichtung verwendeten Metallionen sehr gut zur Beschichtung von Kunststoffoberflächen, weil die ersten Atome der Metallbeschichtung gleichsam in das Kunststoffgitter "hineingeschossen" werden, wodurch eine Art Dotierung erfolgt, die eine innige Verbindung zwischen der Metallschicht und der Trägerplatte gewährleistet.

Mit dem erfindungsgemäßen Verfahren läßt sich eine kostengünstige dünne und sehr gleichmäßige Beschichtung erzielen, die erheblich besser an der Trägerplatte haftet und somit ein leichtes und konturscharfes Abziehen der Abdeckfolie ermöglicht. Während mit den herkömmlichen Bedampfungsverfahren gleichmäßige, transparente und fest haftende Bedampfungsschichten aus den verschiedensten Metallen und deren Legierungen auf transparenten Trägerplatten aus Kunststoff nur über Haftvermittler erreicht werden können, ist dieser mit dem vorliegenden Verfahren nicht notwendig. Folglich wird damit auch der optische Eindruck in der Durchsicht (Blickrichtung durch die Trägerplatte auf die Bedampfung) nicht negativ beeinflußt.

Darüber hinaus kann diese Art der metallischen Beschichtung vor oder nach einer Verformung der Trägerplatte erfolgen, was bei dem Rollenprägeverfahren technisch nicht möglich ist. Ferner hat sich überraschenderweise herausgestellt, daß die Abdeckfolie bzw. Schablone wesentlich leichter von der Trägerplatte abgezogen werden kann, nach Aufbringen der metallischen Beschichtung, wenn letztere entsprechend der Vorgehensweise nach der Erfindung aufgebracht worden ist, da dann die bei Aufbringung der metallischen Beschichtung im traditionellen Rollenprägeverfahren zu beobachtende Verfestigung der Haftung der Abdeckfolie an der Trägerplatte nicht auftritt.

Weitere Merkmale und Vorteile der Erfindung ergeben sich aus der nachstehenden Beschreibung, in der ein Ausführungsbeispiel anhand einer schematischen Zeichnung im einzelnen erläutert ist.

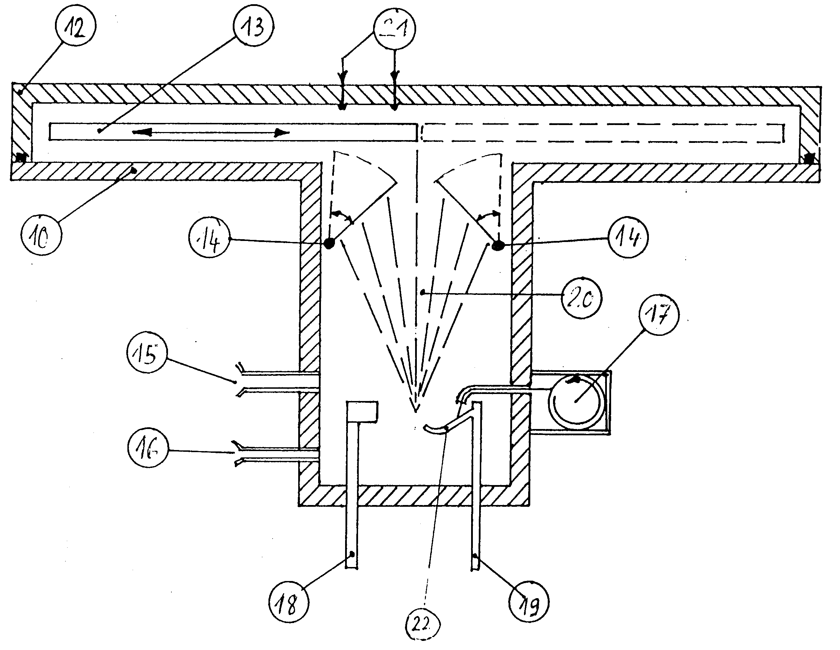

Die Zeichnung zeigt im Schnitt eine Vakuumbeschichtungsanlage für großflächige Trägerplatten insbesondere aus Kunststoff zur Durchführung des erfindungsgemäßen Verfahrens. Eine Vakuumkammer umfaßt ein Vakuumkammer-Unterteil 10 und ein abnehmbares Vakuumkammer-Oberteil 12. Die Außenkontur der Vakuumkammer entspricht im Schnitt einem "T". Das Vakuumkammer-Unterteil 10 weist einen Vakuum-Pumpstutzen 15 und eine Luftzuführungsöffnung 16 auf. Weiterhin weist das Vakuumkammer-Unterteil 10 eine Kathode 18 und eine Anode 19 mit einem Tiegel 22 auf, mittels derer ein im wesentlichen horizontal verlaufender anodischer Vakuumlichtbogen bei Anlegen einer Spannung erzeugt werden kann. Neben der Anode 19 ist eine Zuführeinrichtung 17 für einen Draht aus einer Metallegierung angeordnet, mit der der Draht von oben und oberhalb des Tiegels 22 in den zwischen der Anode 19 und der Kathode 18 erzeugbaren PlasmaVakuumlichtbogen eingeführt werden kann. Oberhalb der aus der Kathode 18 und der Anode 19 mit dem Tiegel 22 bestehenden Verdampfer-Einheit sind zwei über Stellmotoren stufenlos schwenkbare Abdeckblenden 14 angeordnet, um die Schichtdicke durch Verändern des Öffnungswinkels an den einzelnen Abdeckblenden 14 zu steuern. Das Bezugszeichen 13 kennzeichnet einen Schlitten zur Aufnahme einer Trägerplatte (nicht gezeigt), der über Linearmotoren stufenlos verfahrbar ist. Damit ist es z.B. möglich, Trägerplatten, die eine größere als die von der Verdampfer-Einheit beschichtete Fläche aufweisen, durch Verfahren der Trägerplatte quer zu der Bewegungsrichtung des Materialdampfes 20 vollständig und gleichmäßig mit einer Metallegierung zu beschichten.

Das erfindungsgemäße Verfahren wird wie folgt durchgeführt: Nachdem eine Trägerplatte in die Vakuumkammer eingebracht und ein Vakuum erzeugt worden ist, wird durch ein kurzes Kontaktieren der in die Vakuumkammer elektrisch isoliert eingeführten Elektroden (Kathode 18 und Anode 19) oder mit Hilfe einer separaten Zündelektrode (nicht dargestellt) ein Plasma-Vakuumlichtbogen gezündet, in den von oben und oberhalb des Tiegels 22 ein aus einer Metallegierung bestehender Draht derart eingeführt wird, daß sich einzelne Tröpfchen von dem Draht lösen und momentan im wesentlichen vollständig verdampfen. Dieser Materialdampf 20 steigt zu der in dem Schlitten 13 befindlichen Trägerplatte auf, die langsam quer zu der Bewegungsrichtung des Materialdampfes 20 durch das Verdampfungsgebiet der Verdampfer-Einheit bewegt wird. Die gewünschte gleichmäßige Dicke der Metallschicht auf der Trägerplatte wird von Schichtdickenüberwachungssensoren 21 während des Prozesses permanent überwacht und kann über die Vorschubgeschwindigkeit des Drahtes, der Heizleistung der Verdampfer-Einheit und den Öffnungswinkel an den Abdeckblenden 14 geregelt werden. Mit dem vorliegenden erfindungsgemäßen Verfahren können Schichtdicken im Bereich von 40 bis 50 nm und mit einer Toleranz von ± 10 nm über eine Fläche von mehr als einem 1 m² erzielt werden.

Der Tiegel 22 kann auch durch eine entsprechende Gestaltung der Anode 19 bereitgestellt werden.

Selbstverständlich können mehrere der hier beschriebenen Verdampfer-Einheit nebeneinander verwendet werden.

Die in der vorangehenden Beschreibung, in der Zeichnung sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein.

### Bezugszeichenliste

- 10: Vakuum-Unterteil
- 12: Vakuumkammer-Oberteil
- 13: Schlitten für Trägerplatte
- 14: Abdeckblenden
- 15: Vakuum-Pumpstutzen
- 16: Luftzuführungsöffnung
- 17: Zuführeinrichtung für Metallegierung-Draht
- 18: Kathode
- 19: Anode
- 20: Materialdampf
- 21: Schichtdickenüberwachungssensoren
- 22: Tiegel

## Patentansprüche

1. Verfahren zum Versehen einer transparenten Trägerplatte mit einer gleichmäßig dünnen Metallschicht, bei dem auf mindestens eine Seite der Trägerplatte zunächst, vorzugsweise im Siebdruckverfahren, eine Abdeckfolie aufgebracht wird, welche lediglich die nicht zu beschichtenden Bereiche der Trägerplatte abdeckt, anschließend eine Metallschicht mittels eines Plasmabedampfungsverfahrens auf die gesamte, die Abdeckfolie tragende Fläche der Trägerplatte aufgebracht wird, wobei zur Durchführung des Plasmabedampfungsverfahrens mindestens eine eine Kathode und Anode mit einem Tiegel umfassende Verdampfer-Einheit eingesetzt wird, und schließlich die Abdeckfolie von der Trägerplatte entfernt wird, wodurch die Metallschicht lediglich in den zu beschichtenden Bereichen der Trägerplatte auf dieser verbleibt, dadurch gekennzeichnet, daß zur Herstellung der Metallschicht bei jeder Verdampfer-Einheit ein Draht aus einem mindestens ein Metall umfassenden Verdampfungsmaterial von oben und oberhalb des Tiegels in einen zwischen der jeweiligen Anode und dazu im wesentlichen horizontal versetzt angeordneten jeweiligen Kathode bestehenden Plasma-Vakuumlichtbogen derart eingeführt wird, daß sich einzelne Tröpfchen von dem Draht lösen und momentan im wesentlichen vollständig verdampfen, die Schichtdicke in dem der jeweiligen Verdampfer-Einheit zugeordneten Bereich der zu beschichtenden Trägerplatte gemessen wird und die Vorschubgeschwindigkeit des Drahtes sowie die Heizleistung jeder Verdampfer-Einheit zum Erzielen einer vorab festgelegten gleichmäßigen Schichtdicke in Abhängigkeit von dem/den gemessenen schichtdickenwert(en) individuell geregelt werden.

2. Verfahren nach Anspruch 1, dadurch gekennzeichnet, daß der Aufbau jeder Schicht in dem der jeweiligen Verdampfer-Einheit zugeordneten Bereich der zu beschichtenden Trägerplatte in Abhängigkeit von dem/den gemessenen schichtdickenwert(en) mittels jeweils mindestens einer gesteuert zu öffnenden bzw. zu schließenden Blende zusätzlich geregelt wird.

3. Verfahren nach Anspruch 2, dadurch gekennzeichnet, daß die Blende(n) durch schwenken geöffnet bzw. geschlossen wird/werden.

4. Verfahren nach einem der vorangehenden Ansprüche, dadurch gekennzeichnet, daß die Trägerplatte im wesentlichen quer zur Bewegungsrichtung des erzeugten Material-Dampfes bewegt wird.

5. Verfahren nach einem der vorangehenden Ansprüche, dadurch gekennzeichnet, daß die Metallschicht vor einer Verformung der Trägerplatte aufgebracht wird.

6. Verfahren nach einem der Ansprüche 1 bis 4, dadurch gekennzeichnet, daß die Metallschicht nach einer Verformung der Trägerplatte aufgebracht wird.

7. Verfahren nach einem der vorangehenden Ansprüche, dadurch gekennzeichnet, daß die Abdeckfolie durch Abziehen entfernt wird.

8. Verfahren nach einem der Ansprüche 1 bis 6, dadurch gekennzeichnet, daß die Abdeckfolie durch Laserbestrahlung entfernt wird.

9. Verfahren nach einem der Ansprüche 1 bis 6, dadurch gekennzeichnet, daß die Abdeckfolie durch Auswaschen entfernt wird.

10. Verfahren nach einem der Ansprüche 1 bis 6, dadurch gekennzeichnet, daß die Abdeckfolie durch chemisches Ablösen entfernt wird.

11. Verfahren nach einem der Ansprüche 1 bis 6, dadurch gekennzeichnet, daß die Abdeckfolie mittels eines Plottern-Verfahrens entfernt wird.

12. Verfahren nach einem der vorangehenden Ansprüche, dadurch gekennzeichnet, daß auf mindestens eine Seite der Trägerplatte mindestens eine Farbschicht aufgebracht wird.

13. Verfahren nach Anspruch 12, dadurch gekennzeichnet, daß mindestens eine Farbschicht unmittelbar auf die Trägerplatte aufgebracht wird.

14. Verfahren nach Anspruch 12, dadurch gekennzeichnet, daß mindestens eine Farbschicht nach dem Aufbringen der Metallschicht auf diese aufgebracht wird.

15. Verfahren nach Anspruch 12, dadurch gekennzeichnet, daß mindestens eine Farbschicht nach dem Aufbringen der Abdeckfolie auf die diese tragende Trägerplatte aufgebracht wird.

16. Verfahren nach Anspruch 15, dadurch gekennzeichnet, daß mindestens eine Farbschicht vor dem Abziehen der Abdeckfolie auf die Metallschicht aufgebracht wird.

17. Verfahren nach Anspruch 15, dadurch gekennzeichnet, daß mindestens eine Farbschicht nach dem Abziehen der Abdeckfolie aufgebracht wird.

18. Verfahren nach einem der Ansprüche 12 bis 17, dadurch gekennzeichnet, daß mindestens eine Farbschicht selektiv in den mit der Metallschicht versehenen oder zu versehenden Bereichen aufgebracht wird.

19. Verfahren nach einem der Ansprüche 12 bis 18, dadurch gekennzeichnet, daß mindestens eine Farbschicht im Siebdruckverfahren aufgebracht wird.

20. Verfahren nach einem der Ansprüche 12 bis 18, dadurch gekennzeichnet, daß für die Farbschicht eine Farbfolie, vorzugsweise aus Kunststoff bestehend, verwendet wird.

21. Verfahren nach einem der vorangehenden Ansprüche, dadurch gekennzeichnet, daß die gesamte Beschichtung auf die Vorderseite der Trägerplatte aufgebracht wird.

22. Verfahren nach einem der Ansprüche 1 bis 20, dadurch gekennzeichnet, daß die gesamte Beschichtung auf die Rückseite der Trägerplatte aufgebracht wird.

23. Verfahren nach einem der Ansprüche 12 bis 22, dadurch gekennzeichnet, daß als Metallschicht eine Silberlegierung und für mindestens eine Farbschicht mindestens bereichsweise den an sich durch die Silberlegierung bewirkten Silberton der Beschichtung in einen Goldton umwandelnde gelbe Farbe verwendet werden.

24. Verfahren nach einem der Ansprüche 12 bis 22, dadurch gekennzeichnet, daß als Metallschicht eine Goldlegierung verwendet wird.

25. Verfahren nach einem der Ansprüche 12 bis 22, dadurch gekennzeichnet, daß als Metallschicht eine Messinglegierung verwendet wird.

26. Verfahren nach einem der vorangehenden Ansprüche, dadurch gekennzeichnet, daß auf mindestens eine Seite der Trägerplatte eine Schutzschicht aufgebracht wird.

27. Verfahren nach Anspruch 26, dadurch gekennzeichnet, daß die Schutzschicht zuäußerst angeordnet wird.

28. Verfahren nach Anspruch 26 oder 27, dadurch gekennzeichnet, daß die Schutzschicht transparent ist.

29. Verfahren nach einem der vorangehenden Ansprüche, dadurch gekennzeichnet, daß die Trägerplatte aus Glas besteht.

30. Verfahren nach einem der Ansprüche 1 bis 28, dadurch gekennzeichnet, daß die Trägerplatte aus Kunststoff besteht.

31. Verfahren nach Anspruch 30, dadurch gekennzeichnet, daß der Kunststoff Acrylglas umfaßt.

32. Verfahren nach einem der vorangehenden Ansprüche, dadurch gekennzeichnet, daß beide Seiten der Trägerplatte glatt sind.

33. Verfahren nach einem der vorangehenden Ansprüche, dadurch gekennzeichnet, daß mindestens eine der Seiten der Trägerplatte eine Oberflächenstrukturierung aufweist.

34. Verfahren nach Anspruch 33, dadurch gekennzeichnet, daß sich die Oberflächenstrukturierung durch Ätzen ergibt.

35. Verfahren nach Anspruch 33, dadurch gekennzeichnet, daß sich die Oberflächenstrukturierung durch Schleifen ergibt.

36. Verfahren nach einem der Ansprüche 33 bis 35, dadurch gekennzeichnet, daß die Metallschicht auf eine Seite mit der Oberflächenstrukturierung aufgebracht wird.
